# EUROPEAN PATENT SPECIFICATION

(11) **EP 0 361 206 B1**
(45) Date of publication and mention of the grant of the patent: **28.12.1994**
(21) Application number: 89116885.8
(22) Date of filing: 12.09.1989
(51) Int. Cl.: C23C 16/02, C23C 16/26, C23C 16/34, C23C 28/00

(54) **An article coated with a ceramic film**
Mit einem keramischen Film überzogener Gegenstand
Article revêtu d'un film céramique

(30) Priority: 13.09.1988 JP 230787/88; 13.09.1988 JP 230788/88
(43) Date of publication of application: 04.04.1990
(73) Proprietor: SEMICONDUCTOR ENERGY LABORATORY CO., LTD., Atsugi-shi Kanagawa-ken, 243 (JP)
(72) Inventor: Yamazaki, Shunpei, Tokyo 157 (JP); Hayashi, Shigenori, Kanagawa-ken 243 (JP); Hirose, Naoki, Kanagawa-ken 243 (JP); Ishida, Noriya, Kanagawa-ken 243 (JP); Takeyama, Junichi, Kanagawa-ken 243 (JP); Sasaki, Mari, Kanagawa-ken 243 (JP)
(74) Representative: Grünecker, Kinkeldey, Stockmair & Schwanhäusser Anwaltssozietät

(56) References cited:
- EP-A- 0 199 527
- EP-A- 0 278 480
- EP-A- 0 304 220
- CHEMICAL ABSTRACTS, vol. 110, no. 2, 9th January 1989, page 221, abstract no. 11812g, Columbus, Ohio, US; & JP-A-63 140 083
- J.Vac.Sci.Technol. A4(6), Nov./Dec.1986, pages 2661-2669

## Description

The present invention relates to a CVD method for forming an article having a protective translucent film as well as to a wear-resistant bumper, chassis or some othher part of an automobile, ship, aircraft, motorcycle or bicycle comprising a protective, translucent film.

Conventionally, an article e.g. a bumper or other part of a transportation means such as an automobile, ship or aircraft, has a surface painted with an organic paint, which can be exposed to wind and rain as well as being a wind-ward leading edge, so that resistance to wear, adherence of dust, and the creation of static electricity in the painted surface must be prevented.

Generally, the plasma CVD method is an industrially effective method of forming a level film on a substrate with a flat surface in the article as mentioned above. In addition, the sputtering effect using the plasma CVD method is also known as a film forming method.

EP-A-0 278 480 relates to a microwave enhanced CVD method for coating a plastic surface with a carbon film comprising: diagnosing an object having said plastic surface to be coated in a reaction chamber;inputting a reactive gas containing at least a gaseous carbon compound to said reaction chamber; exciting the reactive gas by applying an electromagnetic power; and depositing a carbon layer on said surface by chemical vapor reaction. In one embodiment a photosensitive printing drum is formed by means of plasma CVD.

A typical example of the coating of a carbonaceous film is known from JP-A-56-146936. Therein, a method for forming a carbonaceous film on a flat surface using a self-bias with a substrate provided on one (cathode) electrode of the parallel flat plate type is described.

However, in a conventional example of forming a film using the sputtering effect, a film cannot be formed on a chassis or part, especially on a base member which has an irregular surface, such as on an automobile or motorcycle, or on a large base member such as the chassis of an automobile. For this reason, there is a demand for a method for forming a film in one operation over a large area.

It is the object of the present invention to provide a single-step method for forming an article having over a large area a protective ceramic film with tight adherence to an organic material and which is translucent in the visible region and has adequate hardness, to thus prevent said article from wear, the creation of static electricity, and the adherene of dust as well as a wear-resistant bumper, chassis or other part of an automobile, ship, aircraft, motorcycle or bicycle having such a protective film provided thereon.

According to the present invention this object is attained with a CVD method for forming an article having a protective translucent film comprising the steps of:
providing in a reaction chamber a base member selected from the group of a conductor and a member having a conductive surface having an organic paint coating;
introducing into the reaction chamber a reactive gas forming a translucent film;
supplying the reactive gas with a high frequency power so as to produce a plasma from the reactive gas while an AC and DC bias electric voltage is applied to the base member; and
depositing the translucent film layer on the organic paint coating.

Further, the present invention provides
a wear-resistant bumper, chassis or some other part of an automobile, ship, aircraft, motorcycle or bicycle comprising:
a) a base member selected from the group of a conductor and a member having a conductive surface;
b) an organic paint coating provided on said base member; and
c) a protective film, which is translucent in the visible region and which has adequate hardness, formed on said organic paint coating and selected from a carbonaceous film made of carbon or of a material in which carbon is the main component, or a film of Si₃N₄, SiOₓN_{y}, SiC, ZrO₂ or SiO₂, optionally formed in laminate.

Preferred embodiments of the present invention are set forth in the dependent claims 2-8 and 10-18.

The aforementioned articles or parts are often exposed to wind and rain as well as being a wind-ward leading edge after the surface is painted with an organic coating material. The film according to the present invention provided thereon has water-shedding or water-repellent capabilities, and prevents the accumulation of dust, while it also prevents the development of static electricity which forms easily on a wind-ward leading edge, and the adherence of dust, and abrasion of the painted surfaces from dust thereby preventing the surface from becoming dull, so that the painted surfaces are always maintained in pristine condition. In a preferred embodiment the translucent film according to the present invention is a carbonaceous film, having an electrically inherent resistance of 1 x 10⁷ to 5 x 10¹³ Ωcm, when applied as a protective coating, to a surface of a bumper, chassis or some other part of an automobile, ship or aircraft which is exposed to wind and rain as well as being a wind-ward leading edge after the surface is painted with an organic coating material.

FIG. 1(A) to FIG. 1(C) show an example of a chassis and its main parts coated with a protective coating of a carbonaceous film of carbon, or of a material in which carbon is the main component, according to the present invention.

FIG. 2 is an outline of a plasma CVD production device according to the present invention.

In the method of the present invention, a pair of electrodes used for the plasma polymer, specifically for plasma CVD, are positioned at each end of the reaction chamber with a space therebetween. To provide a coating of organic paint on a substrate which has a conductor or a conductive surface, an AC bias is required with a DC bias overlaid. Then, a first alternate voltage is impressed between the two electrodes to convert the reactive gases to plasma. High frequency voltages at a phase difference of 180 or 0 degrees are applied with respect to ground from individual high frequency power sources on the respective electrodes, and alternate voltages which are mutually symmetrical or the same phase are applied.

As a result, an essentially matched alternate voltage is applied inside a frame structure, and creates a high frequency plasma. The other ends of the high frequency power sources are also grounded, and an additional second alternate voltage is applied via a capacitor to create a DC autobias between these ends and the substrate or substrate holder with a film-forming surface. The substrate or the holder for the substrate is used as a third electrode, and by applying an AC bias to the substrate in accordance with the second alternate voltage a thin film is formed using the sputtering effect.

The first alternate voltage is at a frequency in the range of 1 to 50 MHz, at which a plasma glow discharge is easily produced, and the second alternate voltage is at a frequency in the range of 10 Hz to 500 KHz, at which kinetic energy is easily applied to the reactive gases. In addition a negative DC autobias is overlaid and applied to the substrate holder. When this happens, the plasma-activated gas is accelerated from the autobias on the substrate by the first alternate voltage, and unnecessary charge lingering on the substrate
is removed by the alternating current of the second voltage. The film can be formed on the film-forming surface, even if it is painted with an insulating organic paint.

One example of the forming of the thin film is as follows. First, a carbon fluoride gas from carbon fluorides such as, e.g., C₂F₆, C₃F₈, CF₄ or CH₂F₂ is introduced. Next, a mixture of this gas and hydrogen is converted to a plasma state, or a mixture of these gases and C₂H₄ and a hydrocarbon compound is converted to a plasma state, whereby defluorination followed by decomposition is caused by activated hydrogen, so that diamond-like C-C bonds with SP³ orbits are created, whereby a film with diamond-like characteristics, of which the main component is carbon (the secondary components are mainly hydrogen, fluorine, and nitrogen), containing fluorine or a halogen element, is formed. This film has a specific resistance (inherent resistance) of 1 x 10⁷ to 5 x 10 ¹³ Ωcm, and preferably 1 x 10⁸ to 5 x 10¹¹ Ωcm, and is translucent in the visible range with an optical band width (Eg) of 1.0 eV or greater, and preferably 1.5 to 5.5 eV.

Another example of the forming of the thin film is as follows. First, a gas selected from the group of hydrocarbon gases such as ethylene (C₂H₄), a mixture gas of a hydrocarbon gas and nitrogen fluoride, and a carbon fluoride gas such as, e.g., C₂F₆, C₃F₈, CF₄ or CH₂F₂ is introduced for decomposition, so that diamond-like C-C bonds with SP³ orbits are created, whereby a film with diamond-like characteristics, of carbon, or of which the main component is carbon (the secondary components are mainly hydrogen, fluorine, and nitrogen), is formed. This film has a specific resistance (inherent resistance) of 1 x 10⁷ to 5 x 10¹³ Ωcm, and preferably 1 x 10⁸ to 5 x 10¹¹ Ωcm, and is translucent in the visible range with an optical band width (Eg) of 1.0 eV or greater, and preferably 1.5 to 5.5 eV.

The painted surface used in the present invention can be a polyester resin, an alkyd resin, an oil-free alkyd resin, an unsaturated polyester resin, an acryl resin, or an amino resin. In particular, for an automobile line, a painted surface using an organic melt type of paint such as acryl lacquer, acryl melamine or block acryl urethane is used.

With the method of the present invention, when the film is formed, a halogen element, such as fluorine, and nitrogen are simultaneously added to a carbonaceous gas in plasma CVD.

A single-layered film or a multilayered composite film may be formed wherein the presence of additives is controlled, so that the carbon content or additive content changes with a uniform gradient concentration in the direction of the thickness provided.

### EMBODIMENT NO. 1

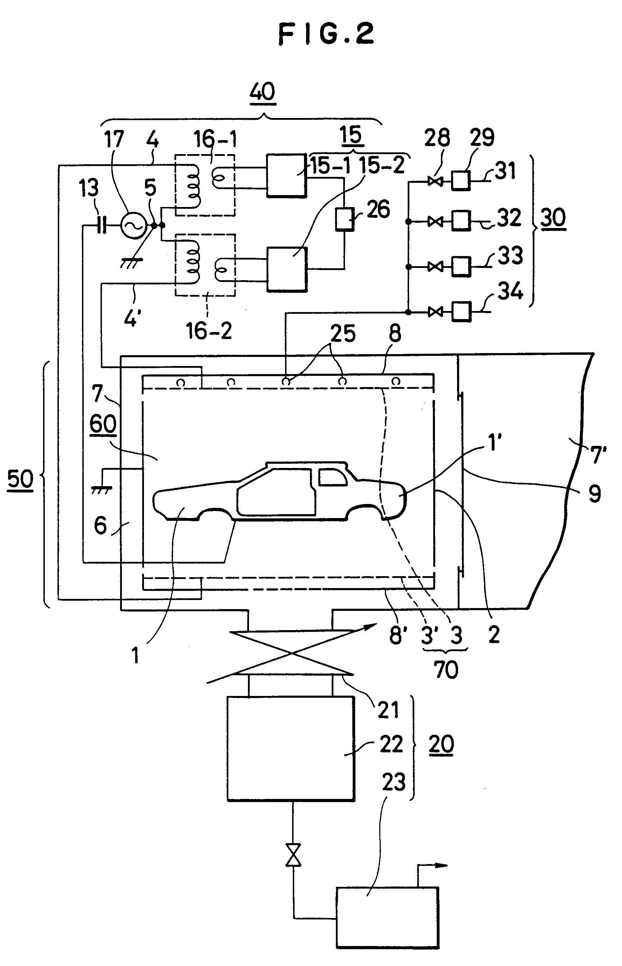

Now referring to FIG. 2, this drawing gives an outline of a plasma CVD device for implementing a method for forming a thin carbonaceous film on a substrate having a conductor or a conducting surface therein for an automobile chassis.

In the drawing, CVD device is separated from a preparation chamber 7' for loading and unloading by a gate valve 9. From a gas system 30, a carrier gas such as argon is introduced through line 31; a reactive gas which is a hydrocarbon gas such as, for example, methane, ethylene, is introduced through line 32: an additive gas such as nitrogen fluoride is introduced through line 33; a gas for etching the reaction vessel, such as oxygen is introduced through line 34. These gases flow through a nozzle 25 into the reaction system 50 via a valve 28 and a flow meter 29. When the ethylene and nitrogen fluoride are introduced, a diamond-like carbonaceous film of 500 to 5000Å (10Å ≙ 1 nm) is formed with carbon and fluorine added therein (which is referred to as DLC). What is meant by DLC in the present invention is the carbonaceous film of carbon, or of a material in which carbon is the main component, which may contain additives.

A film with these same components may be formed by the introduction of C₂F₆, C₃F₈ through line 32, and C₂H₂, or H₂ through line 33.

A film with these same components may be formed by the introduction of C₂F₆, C₃F₈ through line 32, and NH₃ through line 33.

A reaction system 50, is provided with a frame structure 2 (observed to have a quadrilateral frame structure when viewed from the electrode). A pair of hoods 8, 8' are provided to cover the open top and bottom sections. A pair of first and second identically shaped electrodes 3, 3' positioned on the hoods 8, 8' are constructed of aluminum metal mesh. The reactive gases are released in the downward direction from a nozzle 25.

A substrate 1, which is the chassis, bumper, or other parts of the automobile has a base member and a painted surface as a film-forming surface 1' thereon. The base member forms a third electrode, while the painted surface on the base member is an insulated material for DC currents, but when the second alternate voltage is added here so that a bias is applied it is essentially regarded as a conducting body with respect to AC current.

The film-forming surface 1', that is the painted surface of the substrate 1 is positioned and maintained in a plasma created by the pair of electrodes 70(3, 3'). The substrate 1 has a film-forming surface 1' which is a painted organic surface. An alternate voltage of 10 Hz to 500 KHz is applied, in the form that the second alternate voltage and a negative DC bias are applied simultaneously. A glow discharge of reactive gases which are converted to plasma by a first, high frequency alternate voltage is dispersed uniformly throughout the reaction area 60, and the plasma is surrounded by the frame structure 2 and the hoods 8, 8', so that the gases in the plasma state are not released in an outer area 6 and the gases do not adhere to the inner walls of the reaction vessel 7. Also, the electric potential of the plasma is homogeneous in the reaction area.

Furthermore, to make the distribution of the electric potential in the plasma reaction space more uniform, it is possible to apply alternate voltages with two types of frequencies in a power system 40. The first alternate voltage has a high frequency of 1 to 100 MHz, for example, 13.56 MHz and is led from a pair of electrodes 15-1, 15-2 to a pair of matching transformers 16-1, 16-2. The phases of these matching transformers are adjusted by a phase adjuster. They can be out of phase by 180 or 0 degrees. An end 4 and other end 4' of the transformers, which have a symmetrical or the same phase output, are respectively connected to a pair of electrodes comprising a first electrode 3 and a second electrode 3'. Also, a midpoint 5 of the output side of the transformers is maintained in the grounded state, and a second alternate voltage 17 of 10 Hz to 500 KHz, for example, 50 KHz, is applied. The output from the midpoint 5 is connected to the third electrode of the substrate 1 or the holder 2 to which the substrate 1 is electrically connected.

The plasma 60 is created in such a reaction space. Unnecessary or unused gases are discharged through a discharge gas system 20 comprising a pressure regulating valve 21, a turbomolecular pump 22, and a rotary pump 23. These reactive gases have a pressure of 0.13 - 133 Pa (0.001 to 1.0 torr), for example, 6.67 Pa (0.05 torr) in the reaction space 60, and the frame structure 29 is used as an organic-painted surface for the automobile chassis or motorcycle bumper.

In such the space 60, the first high frequency voltage of 5 to 50kW (0.3 to 3 W/cm² per unit area), for example 1kW (0.6 W/cm² per unit area) is applied at a frequency of 13.56 MHz. In addition, by applying an AC bias from the second alternate voltage, a negative autobias voltage of -200 to -600 V (for example, the output of 5 KW) is applied on the film-forming surface. The reactive gases accelerated by the negative autobias voltage form a film on the substrate while effecting sputtering, and thus can form a densified film.

Of course, the height of that quadrilateral shaped (rectangular parallelepiped) frame structure may be 2 to 10m, as required by the design. In addition, the first alternate voltage can be applied between the front and the rear, not between the top and the bottom as shown in the drawing.

The reactive gas is, for example, a mixture of gases of C₂F₆ and C₂H₄. The ratio of C₂F₆ to C₂H₄ is 1/4 to 4/1, typically 1/1. By varying the ratio, it is possible to control the transmissivity and the specific resistance. The temperature of the substrate is maintained at 150°C or less, and typically at room temperature. The film is formed on such a film-forming surface and has a specific resistance of 1 x 10⁷ to 5 x 10¹³ Ωcm. It can be densely formed on an organic resin. A carbonaceous film of carbon, or of a material in which carbon is the main component, to which fluorine is added, with an amorphous structure or a crystalline structure translucent to visible light, is formed at 0.1 to 8 µm, for example 0.5 µm (at flat sections), and 1 to 3 µm ( at projecting sections). The film forming velocity is 100 to 1000Å per minute.

Consequently, on the organic painted surface of the chassis, bumper, or other part which is a substrate, a carbonaceous film of carbon, or of a material in which carbon is the main component can be formed, in particular one containing 30 atomic% of a halogen element such as fluorine, and also, 0.3 to 10 atomic% of nitrogen mixed in. It is also possible to provide a first layer of carbon to a thickness of 100 to 2000Å on an organic painted surface, using ethylene only, then, on top of this, a carbonaceous film, to which is added a halogen element such as fluorine, can also be formed.

### EMBODIMENT NO. 2

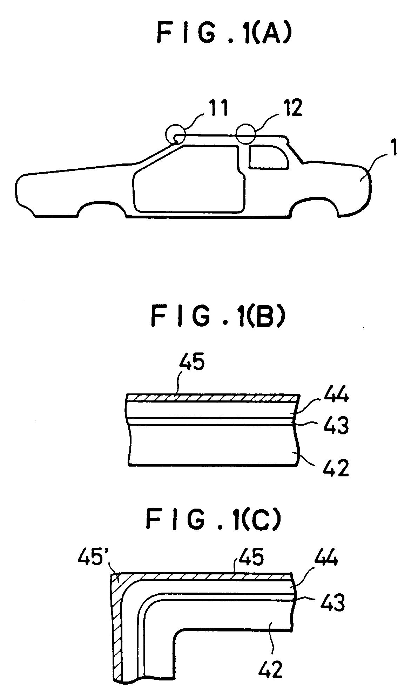

This embodiment is an example of the formation of a carbonaceous film, of which carbon is the main component, on an automobile chassis and its principal parts by means of the device used in Embodiment 1, as shown in FIG. 1(A) to FIG. 1(C). In FIG. 1(A), an automobile chassis in shown in cross-section. FIG. 1(B) and FIG. 1(C) show an enlarged drawing of its principal parts. In FIG. 1(A), (B), and (C), the automobile chassis has a base member 42 of steel. In addition, the base member 42 is subjected to a rust preventive treatment to form an anticorrosive layer 43. An organic paint 44 is then applied to this surface on the request of the customer. For example, a colored acrylic resin can be provided. On the substrate 1 with this film-forming surface 1, an abrasion resistant protective carbonaceous film 45 of carbon, or of a material In which carbon is the main component, is provided to a thickness of 0.1 to 8 µm.

In particular, in the carbonaceous film of carbon or the film of which carbon is the main ingredient to which fluorine is added, its specific resistance is kept in the range of 1 x 10⁷ to 5 x 10¹³ Ωcm and preferably in the range of 1 x 10⁹ to 1 x 10¹¹ Ωcm, so that the formation of static electricity or the adherence of dirt can be prevented.

In FIG. 1(C) a projecting section of the chassis is shown. Since a bias electrical field collects here in the plasma CVD, the velocity of the film forming process is increased, and, as shown, it is possible to form a comparatively thicker film section 45 on the projecting section than on the flat surface. In practical application, such a projecting section is prominent as a wind-ward leading edge and subjected to severe dust collision; therefore it is easily eroded. Accordingly, a thicker coating at these points provides an extremely superior chassis or part.

### EMBODIMENT NO. 3

This embodiment is carried out in a similar manner as EMBODIMENT NO. 1. In this embodiment, however, the reactive gas is, for example, a mixture of gases of ethylene and nitrogen fluoride. The ratio of NF₃ to C₂H₄ is 1/4 to 4/1, typically 1/1. By varying the ratio, it is possible to control the transmissivity and the specific resistance. The temperature of the substrate is maintained at 150°C or less, and typically at room temperature. The film is formed on such a film-forming surface and has a specific resistance of 1 x 10⁷ to 5 x 10¹³ Ωcm. It can be densely formed on an organic resin. A carbonaceous film of carbon, or of a material in which carbon is the main component, to which fluorine and nitrogen are added, with an amorphous structure or a crystalline structure translucent to visible light, was formed at 0.1 to 8 µm, for example 0.5 µm (at flat sections), and 1 to 3 µm (at projecting sections). The film forming velocity was 100 to 1000Å per minute.

Consequently, on the organic painted surface of the chassis, bumper, or other part which is a substrate, a carbonaceous film of carbon, or of a material in which carbon is the main component can be formed, in particular one containing 30 atomic% or less of hydrogen throughout the film, as well as 0.3 to 3 atomic% of a halogen element such as fluorine, and also, 0.3 to 10 atomic% of nitrogen mixed in . It is also possible to provide a first layer of carbon to a thickness of 100 to 2000Å on an organic painted surface, using ethylene only, then, on top of this, a carbonaceous film, to which is added a halogen element such as fluorine, can also be formed.

In the present invention, a single layered carbonaceous film of which carbon is the main ingredient, to which a halogen element such as fluorine is added and having good water-shedding or water-repellent characteristics and a Vickers hardness of 600 to 3000 Kg/mm², is coated on an organic material surface; or, a multilayered film of such carbonaceous materials (with hydrogen added) with a Vickers hardness of 1000 to 7000Kg/mm² is tightly coated on an organic material surface. As a result, it is possible to form a thicker, abrasion-resistant carbonaceous film on projecting sections forming a wind-ward leading edge which are exposed to wind and rain or vulnerable to dust.

With these coatings it is possible to extend the freshness of painted surfaces on for example conventional automobiles for an additional 2 to 3 years and to preserve the color.

In the method of the present invention, DLC (Diamond-Like Carbon) is given as a example of the formed film.

As is clearly understood from the foregoing explanation, the present invention provides a single coating or a multilayered film on an organic resin material. As can be seen from the many embodiments, there are innumerable applications for this composite body, In particular, the carbon can be formed at a temperature of 150°C or less. For this reason, there is no color change caused by a breakdown of the organic painted surface of the substrate, and the hardness of the film and the adherence of the film to the substrate are highly superior in the present coating technology.

The present invention is not limited to the carbonaceous film formation, but can be applied to the coating of other ceramic films on articles, such as Si₃N₄, SiOₓN_{y}, ZrO₂ or SiO₂ coatings. In case of Si₃N₄, the deposition conditions described in the EMBODIMENT No. 1 can be employed except that the reactive gas is replaced by NH₃, Si₂H₆ and N₂ (carrier gas) to be introduced in the ratio of 1/3/5 at 1.3 - 133 Pa (0.01 to 1 Torr). The reaction of 3Si₂H₆+4N₂→2Si₃N₄+9H₂ takes place. SiOₓH_{y} films of 100 to 1000Å thickness can be deposited in accordance with the reaction of Si₂H₆+yN₂+xN₂O→2SiO_{2/x}N_{y}+xN₂+3H₂, in which the content of N₂ is about 1 to 5%. SiC films can be deposited in accordance with the reaction of 2SiH₄+C₂H₆ 2SiC+7H₂. These films can be formed in laminate.

## Claims

1. A wear-resistant bumper, chassis or some other part of an automobile, ship, aircraft, motorcycle or bicycle comprising:
a) a base member selected from the group of a conductor and a member having a conductive surface;
b) an organic paint coating provided on said base member; and
c) a protective film, which is translucent in the visible region and which has adequate hardness, formed on said organic paint coating and selected from a carbonaceous film made of carbon or of a material in which carbon is the main component, or a film of Si₃N₄, SiOₓN_{y}, SiC, ZrO₂ or SiO₂, optionally formed in laminate.

2. The wear-resistant bumper, chassis or some other part of an automobile, ship, aircraft, motorcycle or bicycle of claim 1, wherein the translucent film is a carbonaceous film having diamond-like C-C bonds with sp³ orbits.

3. The wear-resistant bumper, chassis or some other part of an automobile, ship, aircraft, motorcycle or bicycle of claim 2, wherein the carbonaceous film includes nitrogen and a halogen.

4. The wear-resistant bumper, chassis or some other part of an automobile, ship, aircraft, motorcycle or bicycle of claim 3, wherein said halogen is fluorine.

5. The wear-resistant bumper, chassis or some other part of an automobile, ship, aircraft, motorcycle or bicycle of claim 1, wherein the carbonaceous film has a thickness in the range of 0.1 to 8 µm.

6. The wear-resistant bumper, chassis or some other part of an automobile, ship, aircraft, motorcycle or bicycle of claim 2, wherein the carbonaceous film has at least one of a water-repellent property and a water-shedding property.

7. The wear-resistant bumper, chassis or some other part of an automobile, ship, aircraft, motorcycle or bicycle of claim 2, wherein the carbonaceous film has an inherent resistance in the range of 1 x 10⁷ to 5 x 10¹³ Ω cm.

8. The wear-resistant bumper, chassis or some other part of an automobile, ship, aircraft, motorcycle or bicycle of claim 2, wherein the organic paint coating has an inherent resistance of at least 1 x 10¹⁵ Ω cm.

9. A CVD method for forming an article having a protective translucent film comprising the steps of:
providing in a reaction chamber a base member having an organic paint coating, said base member being, selected from the group of a conductor and a member having a conductive surface;
introducing into the reaction chamber a reactive gas forming a translucent film;
supplying the reactive gas with a high frequency power so as to produce a plasma from the reactive gas while an AC and DC bias electric voltage is applied to the base member;
and
depositing the translucent film layer on the organic paint coating.

10. The method of claim 9, wherein the base member has convex and concave sections, and the bias electric field formed is more concentrated on the convex section of the base member than on the concave section of the base member to form a thicker translucent protective film on the convex section.

11. The method of claim 9 wherein the translucent film is selected from a carbonaceous film made of carbon or of a material in which carbon is the main component, or a film of Si₃N₄, SiOₓN_{y}, SiC, ZrO₂ or SiO₂, optionally formed in laminate.

12. The method of claim 9, wherein the translucent film is a carbonaceous film having diamond-like C-C bonds with sp³ orbits.

13. The method of claim 12, wherein the carbonaceous film includes nitrogen and a halogen.

14. The method of claim 13, wherein said halogen is fluorine.

15. The method of claim 9, wherein the carbonaceous film has a thickness in the range of 0.1 to 8 µm.

16. The method of claim 12, wherein the carbonaceous film has at least one of a water-repellent property and a water-shedding property.

17. The method of claim 12, wherein the carbonaceous film has an inherent resistance in the range of 1 x 10⁷ to 5 x 10¹³ Ω cm.

18. The method of claim 12, wherein the organic paint coating has an inherent resistance of at least 1 x 10¹⁵ Ω cm.

## Patentansprüche

1. Verschleißbeständiger Stoßfänger, Fahrgestell oder anderes Teil eines Fahrzeuges, Schiffes, Flugzeuges, Motorrades oder Fahrrades, umfassend:
(a) ein Basisteil, ausgewählt aus der Gruppe eines Stromleiters und eines Teils mit einer leitfähigen Oberfläche;
(b) einen organischen Farbanstrich auf dem Basisteil und
(c) einen Schutzfilm, der im sichtbaren Bereich lichtdurchlässig ist und eine angemessene Härte aufweist, gebildet auf dem organischen Farbanstrich und ausgewählt aus einem kohlenstoffhaltigen Film, hergestellt aus Kohlenstoff oder einem Material, in dem Kohlenstoff der Hauptbestandteil ist, oder einem Film aus Si₃N₄, SiOₓN_{y}, SiC, ZrO₂ oder SiO₂, gegebenenfalls als Laminat gebildet.

2. Verschleißbeständiger Stoßfänger, Fahrgestell oder anderes Teil eines Fahrzeuges, Schiffes, Flugzeuges, Motorrades oder Fahrrades nach Anspruch 1, wobei der lichtdurchlässige Film ein kohlenstoffhaltiger Film mit diamantähnlichen C-C-Bindungen mit sp³-Orbitalen ist.

3. Verschleißbeständiger Stoßfänger, Fahrgestell oder anderes Teil eines Fahrzeuges, Schiffes, Flugzeuges, Motorrades oder Fahrrades nach Anspruch 2, wobei der kohlenstoffhaltige Film Stickstoff und ein Halogen enthält.

4. Verschleißbeständiger Stoßfänger, Fahrgestell oder anderes Teil eines Fahrzeuges, Schiffes, Flugzeuges, Motorrades oder Fahrrades nach Anspruch 3, wobei das Halogen Fluor ist.

5. Verschleißbeständiger Stoßfänger, Fahrgestell oder anderes Teil eines Fahrzeuges, Schiffes, Flugzeuges, Motorrades oder Fahrrades nach Anspruch 1, wobei der kohlenstoffhaltige Film eine Dicke in dem Bereich von 0,1 bis 8 µm aufweist.

6. Verschleißbeständiger Stoßfänger, Fahrgestell oder anderes Teil eines Fahrzeuges, Schiffes, Flugzeuges, Motorrades oder Fahrrades nach Anspruch 2, wobei der kohlenstoffhaltige Film eine wasserabweisende Eigenschaft und/oder eine Wasserabscheideeigenschaft hat.

7. Verschleißbeständiger Stoßfänger, Fahrgestell oder anderes Teil eines Fahrzeuges, Schiffes, Flugzeuges, Motorrades oder Fahrrades nach Ansrpuch 2, wobei der kohlenstoffhaltige Film einen inherenten Widerstand in dem Bereich von 1 x 10⁷ bis 5 x 10¹³ Ω cm hat.

8. Verschleißbeständiger Stoßfänger, Fahrgestell oder anderes Teil eines Fahrzeuges, Schiffes, Flugzeuges, Motorrades oder Fahrrades nach Anspruch 2, wobei der organische Farbanstrich einen inherenten Widerstand von mindestens 1 x 10¹⁵ Ω cm hat.

9. CVD-Verfahren zum Herstellen eines Gegenstandes mit einem schützenden, lichtdurchlässigen Film, umfassend die folgenden Stufen:
- Bereitstellen eines Basisteils mit einem organischen Farbanstrich in einer Reaktionskammer, wobei das Basisteil ausgewählt ist aus der Gruppe eines Stromleiters und eines Teils mit einer leitfähigen Oberfläche;
- Einführen eines reaktiven Gases, das einen lichtdurchlässigen Film bildet, in die Reaktionskammer;
- Bereitstellen des reaktiven Gases mit einer Hochfrequenzleistung, um ein Plasma aus dem reaktiven Gas zu bilden, während an das Basisteil eine elektrische Gleichstrom- und Wechselstromvorspannung angelegt wird; und
- Abscheiden der lichtdurchlässigen Filmschicht auf dem organischen Farbanstrich.

10. Verfahren nach Anspruch 9, wobei das Basisteil konvexe und konkave Abschnitte hat und das gebildete, elektrische Vorspannungsfeld auf dem konvexen Abschnitt des Basisteils stärker konzentriert ist als auf dem konkaven Abschnitt des Basisteils, um auf dem konvexen Abschnitt einen dickeren, lichtdurchlässigen Schutzfilm zu bilden.

11. Verfahren nach Anspruch 9, wobei der lichtdurchlässige Film ausgewählt ist aus einem kohlenstoffhaltigen Film, hergestellt aus Kohlenstoff oder einem Material, worin Kohlenstoff der Hauptbestandteil ist, oder einem Film aus Si₃N₄, SiOₓN_{y}, SiC, ZrO₂ oder SiO₂ gegebenenfalls als Laminat gebildet.

12. Verfahren nach Anspruch 9, wobei der lichtdurchlässige Film ein kohlenstoffhaltiger Film mit diamantähnlichen C-C-Bindungen mit sp³-Orbitalen ist.

13. Verfahren nach Anspruch 12, wobei der kohlenstoffhaltige Film Stickstoff und ein Halogen enthält.

14. Verfahren nach Anspruch 13, wobei das Halogen Fluor ist.

15. Verfahren nach Anspruch 9, wobei der kohlenstoffhaltige Film eine Dicke in dem Bereich von 0,1 bis 8 µm aufweist.

16. Verfahren nach Anspruch 12, wobei der kohlenstoffhaltige Film mindestens eine wasserabweisende Eigenschaft und/oder eine Wasserabscheideeigenschaft hat.

17. Verfahren nach Anspruch 12, wobei der kohlenstoffhaltige Film einen inherenten Widerstand in dem Bereich von 1 x 10⁷ bis 5 x 10¹³ Ω cm hat.

18. Verfahren nach Anspruch 12, wobei der organische Farbanstrich einen inherenten Widerstand von mindestens 1 x 10¹⁵ Ω cm hat.

## Revendications

1. Pare-chocs, châssis ou quelqu'autre pièce de voiture, navire, avion, motocyclette ou bicyclette résistant à l'usure et comprenant:
a) un élément de base choisi parmi le groupe composé d'un conducteur et d'un élément présentant une surface conductrice,
b) un revêtement de peinture organique prévu sur ledit élément de base, et
c) un film protecteur qui est translucide dans la plage visible et qui a une dureté appropriée, formé sur ledit revêtement de peinture organique et choisi parmi un film carboné réalisé en carbone ou en un matériau dans lequel le carbone est le composant principal, ou un film de Si₃N₄, SiOₓN_{y,} SiC, ZrO₂ ou SiO₂, optionnellement formé en laminé.

2. Pare-chocs, châssis ou quelqu'autre pièce de voiture, navire, avion, motocyclette ou bicyclette résistant à l'usure suivant la revendication 1, dans lequel le film translucide est un film carboné ayant des liaisons C-C ressemblant à du diamant avec des orbites sp³.

3. Pare-chocs, châssis ou quelqu'autre pièce de voiture, navire, avion, motocyclette ou bicyclette résistant à l'usure suivant la revendication 2, dans lequel le film carboné comporte de l'azote et un halogène.

4. Pare-chocs, châssis ou quelqu'autre pièce de voiture, navire, avion, motocyclette ou bicyclette résistant à l'usure suivant la revendication 3, dans lequel ledit halogène est le fluor.

5. Pare-chocs, châssis ou quelqu'autre pièce de voiture, navire, avion, motocyclette ou bicyclette résistant à l'usure suivant la revendication 1, dans lequel le film carboné a une épaisseur de l'ordre de 0,1 à 8 µm.

6. Pare-chocs, châssis ou quelqu'autre pièce de voiture, navire, avion, motocyclette ou bicyclette résistant à l'usure suivant la revendication 2, dans lequel le film carboné présente au moins l'une parmi les propriétés de rejet de l'eau et de repoussée de l'eau.

7. Pare-chocs, châssis ou quelqu'autre pièce de voiture, navire, avion, motocyclette ou bicyclette résistant à l'usure suivant la revendication 2, dans lequel le film carboné a une résistance inhérente de l'ordre de 1 x 10⁷ à 5 x 10¹³ Ωcm.

8. Pare-chocs, châssis ou quelqu'autre pièce de voiture, navire, avion, motocyclette ou bicyclette résistant à l'usure suivant la revendication 2, dans lequel le revêtement de peinture organique a une résistance inhérente d'au moins 1 x 10¹⁵ Ωcm.

9. Procédé de DCV pour la formation d'un article revêtu d'un film protecteur translucide, comprenant les étapes consistant à:
prévoir dans une chambre de réaction un élément de base présentant un revêtement de peinture organique, ledit élément de base étant choisi parmi le groupe composé d'un conducteur et d'un élément présentant une surface conductrice,
introduire dans la chambre de réaction un gaz de réaction formant un film translucide,
alimenter le gaz de réaction avec un courant à haute fréquence, de manière à produire un plasma à partir du gaz de réaction, tandis qu'une tension électrique à polarisation de CA et de CC est appliquée sur l'élément de base, et
déposer la couche de film translucide sur le revêtement de peinture organique.

10. Procédé suivant la revendication 9, dans lequel l'élément de base présente des segments convexe et concave et le champ électrique à polarisation formé est plus concentré sur le segment convexe de l'élément de base que sur le segment concave de l'élément de base, pour former un film protecteur translucide sur le segment convexe.

11. Procédé suivant la revendication 9, dans lequel le film translucide est choisi parmi un film carboné réalisé en carbone ou en un matériau dans lequel le carbone est le composant principal, ou un film de Si₃N₄, SiOₓN_{y}, SiC, ZrO₂ ou SiO₂, optionnellement formé en laminé.

12. Procédé suivant la revendication 9, dans lequel le film translucide est un film carboné ayant des liaisons C-C ressemblant à du diamant avec des orbites sp³.

13. Procédé suivant la revendication 12, dans lequel le film carboné comporte de l'azote et un halogène.

14. Procédé suivant la revendication 13, dans lequel ledit halogène est le fluor.

15. Procédé suivant la revendication 9, dans lequel le film carboné a une épaisseur de l'ordre de 0,1 à 8 µm.

16. Procédé suivant la revendication 12, dans lequel le film carboné présente au moins l'une parmi les propriétés de rejet de l'eau et de repoussée de l'eau.

17. Procédé suivant la revendication 12, dans lequel le film carboné a une résistance inhérente de l'ordre de 1 x 10⁷ à 5 x 10¹³ Ωcm.

18. Procédé suivant la revendication 12, dans lequel le revêtement de peinture organique a une résistance inhérente d'au moins 1 x 10¹⁵ Ωcm.
